(19) Europäisches Patentamt / European Patent Office / Office européen des brevets

(11) **EP 2 632 049 B1**

(12) **EUROPEAN PATENT SPECIFICATION**

(45) Date of publication and mention
of the grant of the patent:
**09.09.2015 Bulletin 2015/37**

(21) Application number: **12275104.3**

(22) Date of filing: **11.07.2012**

(51) Int Cl.:
*H03L 7/18* (2006.01)     *H03L 7/085* (2006.01)

(54) **All digital phase locked loop and method of controlling the same**

Vollständig digitaler Phasenregelkreis und Verfahren zu dessen Steuerung

Boucle numérique à verrouillage de phase et son procédé de commande

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.02.2012 KR 20120019677**

(43) Date of publication of application:
**28.08.2013 Bulletin 2013/35**

(73) Proprietor: **Samsung Electro-Mechanics Co., Ltd
Suwon, Gyunggi-Do (KR)**

(72) Inventors:
• **Kim, Yoo Hwan
Gyunggi-do (KR)**
• **Na, Yoo Sam
Gyunggi-do (KR)**

(74) Representative: **Potter Clarkson LLP
The Belgrave Centre
Talbot Street
Nottingham, NG1 5GG (GB)**

(56) References cited:
**US-A1- 2008 315 928     US-A1- 2009 052 508
US-A1- 2010 066 421**

**Description**

**BACKGROUND OF THE INVENTION**

**Field of the Invention**

The present invention relates to an all digital phase locked loop which may be applied to a communications system to improve frequency resolution using frequency interpolation.

**Description of the Related Art**

A frequency synthesizer used for existing communications systems may, for example, include an analog phase locked loop (PLL) and a digital phase locked loop.

First, in the case of an analog phase locked loop, an analog circuit manufactured separately from a digital library during the manufacturing process may be designed.

The analog phase locked loop may consume excessive amounts of time and costs in designing a circuit according to a change in a process thereof, and may also deteriorate operational characteristics of a communications system due to lowering an amount of supplied power.

A digital phase locked loop has been researched and developed so as to solve defects inherent in the analog phase locked loop.

The digital phase locked loop may generate an oscillation signal having a required frequency by a process of controlling a frequency of an oscillation signal according to a phase difference between the oscillation signal and a reference signal.

The digital phase locked loop as described above can be more easily designed with regard to a change in a process thereof through the development of a nanometer-level CMOS process due to the gradual development of technology used therefor, and as a result, the size and current consumption thereof can be comparatively reduced.

However, an existing digital phase locked loop, as described above, controls a frequency phase using a predetermined digital code when the frequency resolution is determined at the time of the manufacturing, and therefore, cannot increase frequency resolution after being manufactured. Therefore, when resolution is required to be higher as needed, a new digital phase locked loop matching the required resolution is needed.

The following Related Art Document relates to a phase locked loop having a self-correction phase-digital transfer function and does not disclose technical features improving frequency resolution using interpolation.

[Related Art Document]

Korean Patent Laid-Open Publication No. 10-2010-0101005

US 2008/0315928 describes a phase locked loop that operates on clock signals derived from an RF clock signal generated by the phase locked loop. A frequency reference input provides a reference clock. A controllable oscillator generates the RF clock signal. A dithering circuit is coupled to the reference signal and injects a short sequence dither signal into the reference signal in order to overcome quantization noise and thereby improve RMS phase-error detection for integer channels.

**SUMMARY OF THE INVENTION**

An aspect of the present invention provides an all digital phase locked loop capable of improving frequency resolution using frequency interpolation.

According to an aspect of the present invention, there is provided an all digital phase locked loop having a phase comparator comparing phases of a target signal having a reference frequency and a digital oscillation feedback signal having a feedback frequency characterised in that said all digital phase locked loop comprises: a virtual value controller setting one of a plurality of preset virtual values between lower and higher digital codes as an initial virtual value when the reference frequency is a frequency included between two preset lower and higher digital codes, and controlling the initial virtual value according to a phase comparison result from the phase comparator to generate an adjusted virtual value; a random number generator generating a random number within a range of the plurality of virtual values; a comparator comparing magnitudes between the adjusted virtual value generated from the virtual value controller and the random number generated from the random number generator to generate digital codes according to the comparison result; and a digitally controlled oscillator generating an oscillation signal according to the digital codes from the comparator.

The all digital phase locked loop may further include: a digital filter filtering the digital codes from the comparator;

and a divider dividing the oscillation signal from the digitally controlled oscillator at a preset dividing ratio to provide the digital oscillation feedback signal having the feedback frequency.

The phase comparator may provide a lead phase difference signal when the phase of the target signal leads that of the digital oscillation feedback signal and provide a lag phase difference signal when the phase of the target signal lags behind or is equal to that of the digital oscillation feedback signal.

The virtual value controller may provide an adjusted virtual value obtained by adding a preset step value to the initial virtual value when the phase difference signal is the lead phase difference signal, and may provide an adjusted virtual value obtained by subtracting the preset step value from the initial virtual value when the phase difference signal is the lag phase difference signal.

The comparator may provide the higher digital code when the adjusted virtual value is higher than the random number and provide the lower digital code when the adjusted virtual value is equal to or lower than the random number.

According to another aspect of the present invention, there is provided a method of controlling an all digital phase locked loop having comparing phases of a target signal having a reference frequency and a digital oscillation feedback signal having a feedback frequency, characterised in that said method of controlling an all digital phase locked loop comprises: setting one of a plurality of preset virtual values between lower and higher digital codes as an initial virtual value when the reference frequency is a frequency included between two preset lower and higher digital codes and controlling the initial virtual value according to a phase comparison result from the phase comparison to generate an adjusted virtual value; generating a random number within a range of the plurality of virtual values; comparing magnitudes of the adjusted virtual value and the random number to generate digital codes according to a comparison result; and generating an oscillation signal according to the digital codes.

The method of controlling an all digital phase locked loop may further include: filtering the digital codes from the generating of the digital codes; and dividing the oscillation signal from the generating of the oscillation signal at a preset dividing ratio to provide the digital oscillation feedback signal having the feedback frequency.

In the comparing of the phases, a lead phase difference signal may be provided when the phase of the target signal leads that of the digital oscillation feedback signal, and a lag phase difference signal may be provided when the phase of the target signal lags behind or is equal to that of the digital oscillation feedback signal.

In the controlling of the virtual value, an adjusted virtual value obtained by adding a preset step value to the initial virtual value may be provided when the phase difference signal is the lead phase difference signal, and an adjusted virtual value obtained by subtracting the preset step value from the initial virtual value may be provided when the phase difference signal is the lag phase difference signal.

In the generating of the digital code, the higher digital code may be provided when the adjusted virtual value is higher than the random number, and the lower digital code may be provided when the adjusted virtual value is equal to or lower than the random number.

## BRIEF DESCRIPTION OF THE DRAWINGS

The above and other aspects, features and other advantages of the present invention will be more clearly understood from the following detailed description taken in conjunction with the accompanying drawings, in which:

FIG. 1 is a block diagram of an all digital phase locked loop provided in accordance with a first embodiment of the present invention;
FIG. 2 is a diagram for describing an operation of a phase comparator in accordance with the first embodiment of the present invention;
FIG. 3 is a diagram for describing a virtual value of a virtual value controller in accordance with the first embodiment of the present invention;
FIG. 4 is a diagram for describing an operation of the virtual value controller in accordance with the first embodiment of the present invention;
FIG. 5 is a flow chart of a method of controlling an all digital phase locked loop provided in accordance with a second embodiment of the present invention;
FIG. 6 is a flow chart of a phase comparison process in accordance with a second embodiment of the present invention;
FIG. 7 is a flow chart of a virtual value control process in accordance with the second embodiment of the present invention; and
FIG. 8 is a flow chart of a digital code generation process in accordance with the second embodiment of the present invention.

**DETAILED DESCRIPTION OF THE EMBODIMENTS**

Embodiments of the present invention will now be described in detail with reference to the accompanying drawings.

The present invention should not be limited to the embodiments set forth herein and the embodiments may be used to assist in understanding the technical idea of the present invention. Like reference numerals designate like components having substantially the same constitution and function in the drawings of the present invention.

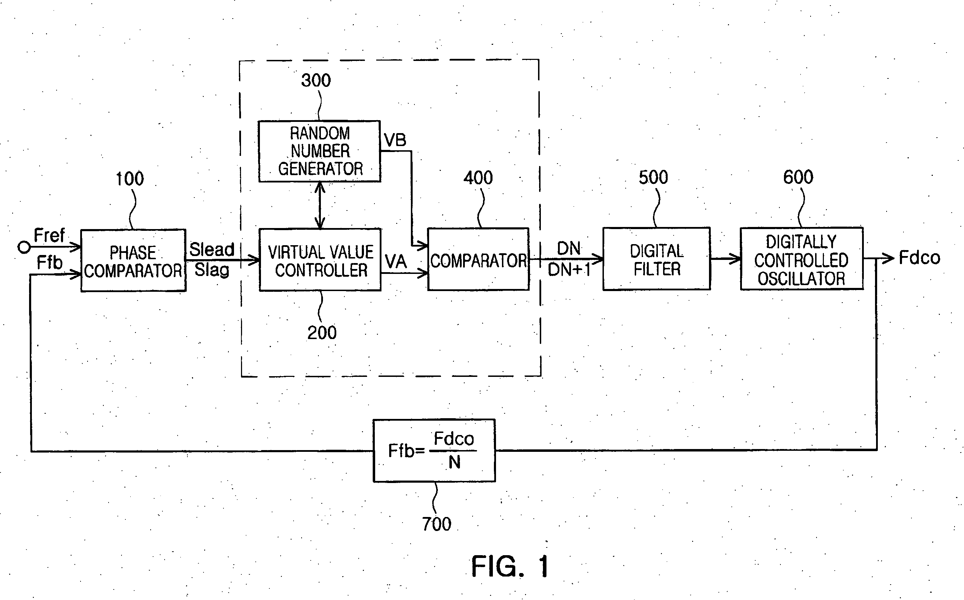

FIG. 1 is a block diagram of an all digital phase locked loop provided in accordance with a first embodiment of the present invention.

Referring to FIG. 1, an all digital phase locked loop provided in accordance with a first embodiment of the present invention may include a phase comparator 100 that compares phases of a target signal TS having a reference frequency Fref and a digital oscillation feedback signal DFS having a feedback frequency Ffb; a virtual value controller 200 that sets one of a plurality of preset virtual values between lower and higher digital codes DN and DN+1 as an initial virtual value VS when the reference frequency Fref is a frequency included between two preset lower digital code DN and higher digital code DN+1, and adjusts the initial virtual value VS according to the phase comparison result from the phase comparator 100 to generate an adjusted virtual value VA; a random number generator 300 that generates a random number VB within a range of the plurality of virtual values; a comparator 400 that compares magnitudes between the adjusted virtual value VA generated from the virtual value controller 200 and the random number VB generated from the random number generator 300 to generate the digital codes according to the comparison result; and a digitally controlled oscillator 600 that generates an oscillation signal according to the digital codes from the comparator 400.

Further, the all digital phase locked loop provided in accordance with the first embodiment of the present invention may further include a digital filter 500 that filters the digital codes from the comparator 400 and a divider 700 that divides the oscillation signal from the digitally controlled oscillator 600 at a preset dividing ratio to provide the digital oscillation feedback signal DFS having the feedback frequency Ffb.

In this configuration, the phase comparator 100 may compare phases of the target signal TS having the reference frequency Fref and the digital oscillation feedback signal DFS having the feedback frequency Ffb to output a signal corresponding to a phase difference between the target signal TS and the digital oscillation feedback signal DFS.

In the all digital phase locked loop provided in accordance with the first embodiment of the present invention, when the digital codes may be previously set to control the oscillation frequency, any two adjacent digital codes 'DN' and 'DN+1' may be referred to as the lower digital code and the higher digital code. This description may be applied to another embodiment of the present invention.

The virtual value controller 200 may set one of the plurality of preset virtual values between the lower and higher digital codes DN and DN+1, as the initial virtual value VS, when the reference frequency Fref is a frequency included between two preset lower digital code DN and higher digital code DN+1. In this case, when the plurality of subdivided virtual values are obtained between the lower digital code DN and the higher digital code DN+1, frequency resolution may be increased by the number of the plurality of virtual values.

In this case, the virtual value controller 200 may generate the adjusted virtual value VA by controlling the initial virtual value VS according to the phase comparison results from the phase comparator 100.

Unlike this, when the reference frequency Fref corresponds to one of the lower digital code DN and the higher digital code DN+1 rather than being included between the lower digital code DN and the higher digital code DN+1, the digitally controlled oscillator 600 may generate the oscillation signal using a corresponding digital code without needing to control the virtual value control process.

The random number generator 300 may randomly generate the random number VB within the range of the plurality of virtual values according to a method of generating a preset random number. Here, the method of generating a random number is a method of generating a random number that permits overlaps. One of the known methods for generating a random number may be used and is not particularly limited to the specific method.

The comparator 400 may compare magnitudes between the adjusted virtual value VA generated from the virtual value controller 200 and the random number VB generated from the random number generator 300 to generate one of the lower digital code DN and the higher digital code DN+1 according to the comparison result.

Further, the digitally controlled oscillator 600 may generate an oscillation signal according to digital codes from the comparator 400.

For example, the digitally controlled oscillator 600 may generate an oscillation signal corresponding to the lower digital code DN when the lower digital code DN is provided from the comparator 400 and may generate an oscillation signal corresponding to the higher digital code DN+1 when the higher digital code DN+1 is provided from the comparator 400.

Further, when the all digital phase locked loop provided in accordance with the first embodiment of the present invention further includes a digital filter 500 and a divider 700, the digital filter 500 may filter the digital codes from the comparator 400 and provide the filtered digital codes to the digitally controlled oscillator 600.

In addition, the divider 700 may divide an oscillation signal Fdco from the digitally controlled oscillator 600 at a preset dividing ratio N and may provide the digital oscillation feedback signal DFS having a feedback frequency Ffb = Fdco/N to the phase comparator 100.

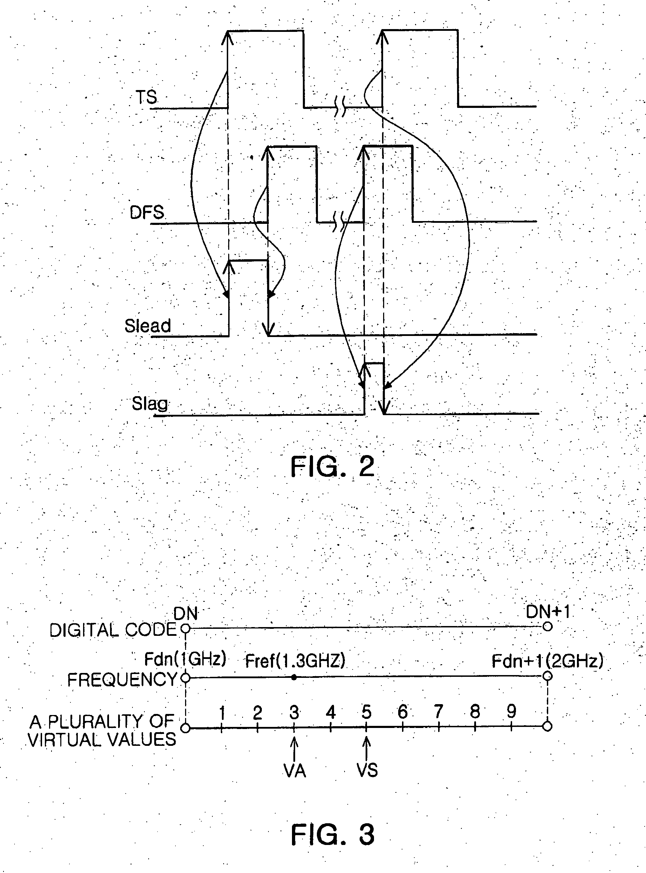

FIG. 2 is a diagram for describing an operation of the phase comparator in accordance with the first embodiment of the present invention.

Referring to FIGS. 1 and 2, the phase comparator 100 may compare the phases between the target signal TS and the digital oscillation feedback signal DFS to provide a lead phase difference signal Slead having high-level sustained time corresponding to the phase difference between the two signals when the phase of the target signal TS leads that of the digital oscillation feedback signal DFS.

In addition, the phase comparator 100 may provide a lag phase difference signal Slag having the high-level sustained time corresponding to the phase difference between the two signals when the phase of the target signal TS lags behind that of the digitally controlled feedback signal DFS, that is, the phase of the target signal TS lags behind or is equal to that of the digital oscillation feedback signal DFS.

FIG. 3 is a diagram for describing a virtual value of a virtual value controller in accordance with the first embodiment of the present invention.

Referring to FIG. 3, the frequency that may be generated by the lower digital code DN and the higher digital code DN+1, respectively, may also be a lower frequency Fdn and a higher frequency Fdn+1.

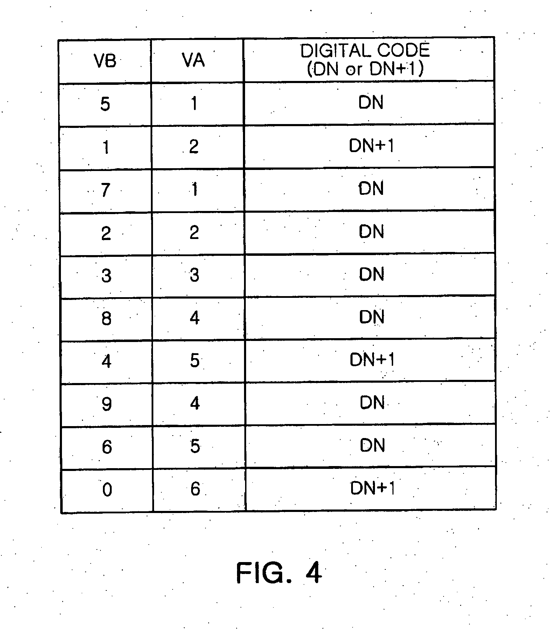

FIG. 4 is a diagram for describing an operation of the virtual value controller in accordance with the first embodiment of the present invention.

Referring to FIG. 4, the virtual value controller 200 may provide the adjusted virtual value VA obtained by adding a preset step value to the initial virtual value when the phase difference signal is a lead phase difference signal Slead and may provide the adjusted virtual value VA obtained by subtracting the preset step value from the initial virtual value when the phase difference signal is a lag phase difference signal Slag.

In this case, when the adjusted virtual value VA is higher than the random number VB, the comparator 400 may provide the higher digital code DN+1 and when the adjusted virtual value VA is equal to or lower than the random number VB, the comparator 400 may provide the lower digital code DN.

Referring to FIGS. 3 and 4, a plurality of virtual values may be set between the lower digital code DN and the higher digital code DN+1. In this case, the number of virtual values may be defined as needed. For example, as shown in FIG. 3, the number of virtual values may be set to be nine (1, 2, 3, 4, 5, 6, 7, 8, 9). In this case, when subdivided nine virtual values are obtained between the lower digital code DN and the higher digital code DN+1, frequency resolution may be increased 10 times as many as nine virtual values.

In this case, the initial virtual value VS may be set to be '5' and the step value, an interval between the plurality of virtual values, may be set to be '1'.

For example, referring to FIG. 3, when the lower frequency Fdn is set to be '1GHz', the higher frequency Fdn+1 is set to be '2GHz', and the reference frequency Fref is set to be '1.3GHz', the lower digital code 'DN' is generated three times and the higher digital code 'DN+1' is generated seven times, between the lower digital code DN and the higher digital code DN+1. In this case, as shown in the following Equation 1, accurate locking with respect to the reference frequency (Fref = 1.3GHz) of the target signal TS may be obtained. As a result, the phase noise characteristics may be improved.

$$
\begin{aligned}
[\text{Equation 1}] \\
\text{Fref} &= (\text{Pdn}/10)*\text{Fdn}+1 + (1-(\text{Pdn}+1/10))*\text{Fdn} \\
&= (7/10)*1(\text{GHz}) + (1- 7/10)*2(\text{GHz}) \\
&= 0.7(\text{GHz}) + 0.6(\text{GHz}) \\
&= 1.3(\text{GHz})
\end{aligned}
$$

In Equation 1, Pdn represents a frequency of the lower digital code (DN) and Pdn+1 represents a frequency of the higher digital code (DN+1).

As a result, referring to FIG. 3, the initial virtual value VS '5' may be controlled to '4' and then, may be controlled to '3', such that the adjusted virtual value VA may be '3'. As described above, a description with reference to FIG. 3 may also be applied to another embodiment of the present invention.

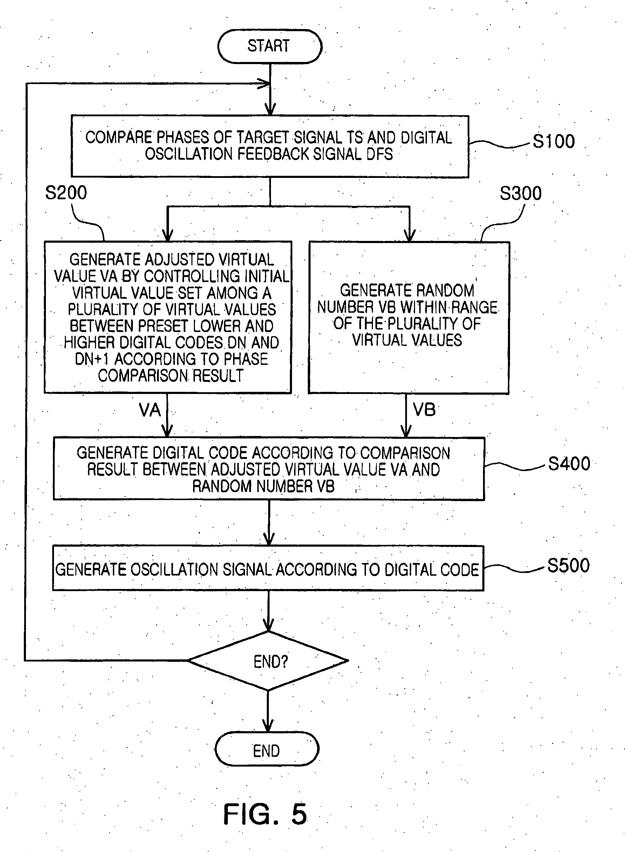

FIG. 5 is a flow chart of a method of controlling an all digital phase locked loop provided in accordance with the second embodiment of the present invention.

Referring to FIG. 5, a method of controlling an all digital phase locked loop provided in accordance with the second embodiment of the present invention may include comparing phases of a target signal TS having a reference frequency Fref and a digital oscillation feedback signal DFS having a feedback frequency Ffb (S100), setting one of a plurality of preset virtual values between lower and higher digital codes DN and DN+1 as an initial virtual value VS when the reference frequency Fref is a frequency included between two preset lower digital code DN and higher digital code DN+1, and controlling the initial virtual value VS according to the phase comparison result from the phase comparison (S100) to generate an adjusted virtual value VA (S200), generating a random number VB within a range of the plurality of virtual values (S300), comparing magnitudes of the adjusted virtual value VA and the random number VB to generate the digital codes according to the comparison result (S400), and generating an oscillation signal according to the digital codes. (S600).

Further, the method of controlling an all digital phase locked loop provided in accordance with the second embodiment of the present invention may further include filtering the digital codes provided from the generating (S400) of the digital codes (S500) and dividing the oscillation signal from the generating of the oscillation signal (S600) at the preset dividing ratio to provide the digital oscillation feedback signal DFS having the feedback frequency Ffb (S700).

In this case, at the phase comparing (S100), the phases between the target signal TS having the reference frequency Fref and the digital oscillation feedback signal DFS having the feedback frequency Ffb may be compared with each other.

In the controlling of the virtual value (S200), one of the plurality of preset virtual values between the lower and higher digital codes DN and DN+1 may be set as the initial virtual value VS when the reference frequency Fref is a frequency included between the preset lower digital code DN and higher digital code DN+1. In this case, when an interval between the lower digital code DN and the higher digital code DN+1 is subdivided into a plurality of virtual values, the frequency resolution may be increased corresponding to the number of the plurality of virtual values.

In this case, the adjusted virtual value VA may be generated by controlling the initial virtual value VS according to the phase comparison result from the comparing of the phases (S100).

In the generating of the random number (S300), the random number VB may be generated within the range of the plurality of virtual values. Here, the method of generating a random number is a method of generating a random number that permits overlaps. A known method of generating a random number may be used and is not particularly limited.

In the generating of the digital codes (S400), the adjusted virtual value VA may be compared with the random number VB to generate one of the lower digital code DN and the higher digital code DN+1 according to the comparison result.

Further, in the generating of the digital oscillation signal (S600), the oscillation signal according to the digital codes may be generated.

For example, in the generating of the digital oscillation signal (S600), an oscillation signal corresponding to the lower digital code DN may be generated when the lower digital code (DN) is provided from the generating of the digital code (S400), and an oscillation signal corresponding to the higher digital code DN+1 may be generated when the higher digital code DN+1 is provided from the generating of the digital code (S400).

Further, the method of controlling an all digital phase in accordance with the second embodiment of the present invention may further include the filtering (S500) and the dividing (S700).

In this case, in the filtering (S500), the digital code from the generating of the digital code (S400) may be filtered.

Further, in the dividing (S700), the oscillation signal from the generating of the oscillation signal (S600) may be divided at the preset dividing ratio to provide the digital oscillation feedback signal DFS having the feedback frequency Ffb.

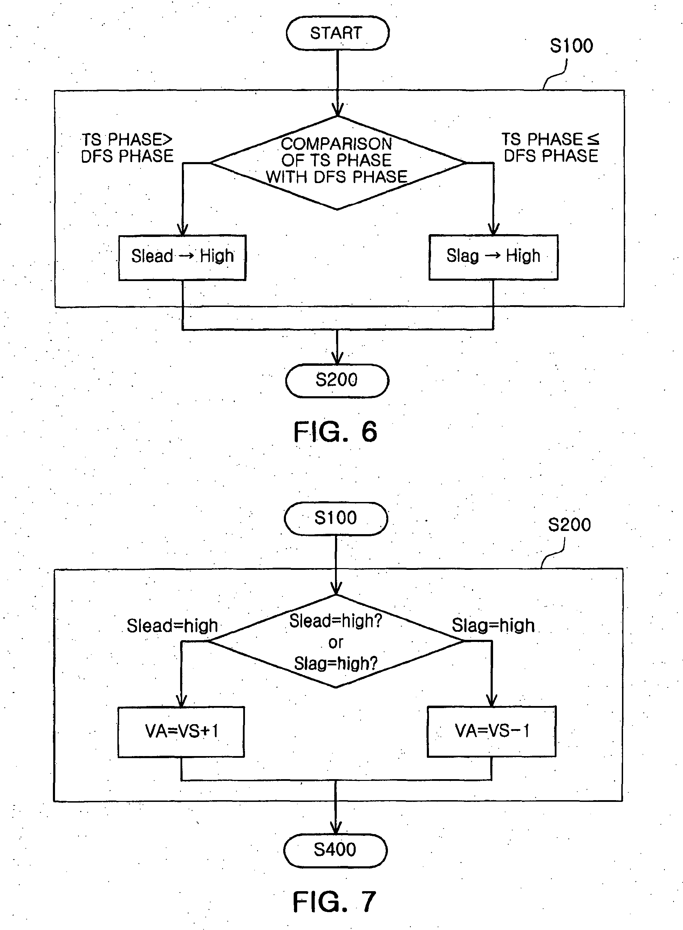

FIG. 6 is a flow chart of the comparing of the phases in accordance with the second embodiment of the present invention.

Referring to FIGS. 5 and 6, at the comparing of the phase (S100), the phase of the target signal TS may be compared with that of the digital oscillation feedback signal DFS to provide the lead phase difference signal Slead when the phase of the target signal TS leads that of the digital oscillation feedback signal DFS.

In addition, the lag phase difference signal Slag having the high-level sustained time corresponding to the phase difference between the two signals may be provided when the phase of the target signal TS lags behind that of the digital oscillation feedback signal DFS, that is, the phase of the target signal TS lags behind or is equal to that of the digital oscillation feedback signal DFS.

FIG. 7 is a flow chart of the controlling of the virtual value in accordance with the second embodiment of the present invention.

Referring to FIGS. 5 to 7, in the controlling of the virtual value (S200), when the phase difference signal is the lead phase difference signal Slead, the adjusted virtual value VA obtained by adding the preset step value to the initial virtual value may be provided.

Further, when the phase difference signal is the lag phase difference signal Slag, the adjusted virtual value VA obtained by subtracting the preset step value from the initial virtual value may be provided.

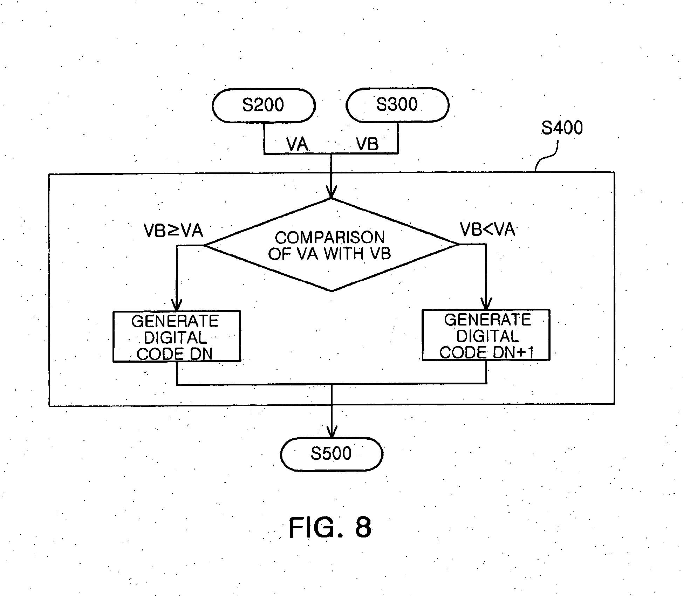

FIG. 8 is a flow chart of the generating of the digital codes in accordance with the second embodiment of the present invention.

Referring to FIGS. 5 to 8, in the generating of the digital codes (S400), when the adjusted virtual value VA is higher than the random number VB, the higher digital code DN+1 may be provided, and when the adjusted virtual value VA is equal to or lower than the random number VB, the lower digital code DN may be provided.

In addition, referring to FIGS. 3 and 4, the plurality of virtual values may be set between the lower digital code DN and the higher digital code DN+1. In this case, the number of virtual values may be determined as needed. For example, as shown in FIG. 3, the number of virtual values may be set to be nine (1, 2, 3, 4, 5, 6, 7, 8, 9) . In this case, when an interval between the lower digital code DN and the higher digital code DN+1 is subdivided into nine virtual values, the frequency resolution may be increased 10 times as many as nine virtual values.

In this case, the initial virtual value VS may be set to be '5' and the step value, an interval between the plurality of virtual values, may be set to be '1'.

For example, referring to FIG. 3, when the lower frequency Fdn is set to be '1GHz', the higher frequency Fdn+1 is set to be '2GHz', and the reference frequency Fref is set to be '1.3GHz'; the lower digital code 'DN' is generated three times and the higher digital code 'DN+1' is generated seven times, between the lower digital code DN and the higher digital code DN+1. In this case, as shown in the following Equation 1, accurate locking with respect to the reference frequency (Fref = 1.3GHz) of the target signal TS may be obtained. As a result, the phase noise characteristics may be improved.

In this case, the initial virtual value VS may be set to be '5' and the step value, an interval between the plurality of virtual values, may be set to be '1'.

As a result, referring to FIG. 3, the initial virtual value VS '5' may be controlled to '4' and then, may be controlled to '3', such that the adjusted virtual value VA may be '3'.

As set forth above, the embodiments of the present invention may be applied to the communications system, and code DN+1. In this case, as shown in the following Equation 1, accurate locking with respect to the reference frequency (Fref = 1.3GHz) of the target signal TS may be obtained. As a result, the phase noise characteristics may be improved.

In this case, the initial virtual value VS may be set to be '5' and the step value, an interval between the plurality of virtual values, may be set to be '1'.

As a result, referring to FIG. 3, the initial virtual value VS '5' may be controlled to '4' and then, may be controlled to '3', such that the adjusted virtual value VA may be '3'.

As set forth above, the embodiments of the present invention may be applied to the communications system, and according to the embodiments of the present invention, .the frequency resolution determined by the digital code using the frequency interpolation may be improved, thereby improving the phase noise characteristics that may occur due to the limited frequency resolution.

While the present invention has been shown and described in connection with the embodiments, it will be apparent to those skilled in the art that modifications and variations can be made without departing from the scope of the invention as defined by the appended claims.

## Claims

1. An all digital phase locked loop having
   a phase comparator (100) for comparing phases of a target signal having a reference frequency (Fref) and a digital oscillation feedback signal having a feedback frequency (Ffb) based on an oscillation signal **characterised in that** said all digital phase locked loop comprises:

   a virtual value controller (200) for setting one of a plurality of preset virtual values between lower and higher digital codes as an initial virtual value when the reference frequency (Fref) is a frequency included between two preset lower and higher digital codes, and for controlling the initial virtual value according to a phase comparison result from the phase comparator (100) to generate an adjusted virtual value;
   a random number generator (300) for generating a random number within a range of the plurality of virtual values;
   a comparator (400) for comparing magnitudes between the adjusted virtual value (VA) generated from the virtual value controller (200) and the random number (VB) generated from the random number generator (300) to generate digital codes according to the comparison result; and
   a digitally controlled oscillator (600) for generating the oscillation signal according to the digital codes from the comparator (400).

2. The all digital phase locked loop of claim 1, further comprising:

a digital filter (500) for filtering the digital codes from the comparator (400); and
a divider (700) for dividing the oscillation signal from the digitally controlled oscillator (600) at a preset dividing ratio to provide the digital oscillation feedback signal having the feedback frequency (Ffb).

3. The all digital phase locked loop of claim 1, wherein the phase comparator (100) is adapted for providing a lead phase difference signal when the phase of the target signal leads that of the digital oscillation feedback signal and is adapted for providing a lag phase difference signal when the phase of the target signal lags behind or is equal to that of the digital oscillation feedback signal.

4. The all digital phase locked loop of claim 3, wherein the virtual value controller (200) is adapted for providing an adjusted virtual value obtained by adding a preset step value to the initial virtual value when the phase difference signal is the lead phase difference signal, and is adapted for providing an adjusted virtual value obtained by subtracting the preset step value from the initial virtual value when the phase difference signal is the lag phase difference signal.

5. The all digital phase locked loop of claim 4, wherein the comparator (400) is adapted for providing the higher digital code when the adjusted virtual value is higher than the random number and is adapted for providing the lower digital code when the adjusted virtual value is equal to or lower than the random number.

6. The all digital phase locked loop of claim 5, adapted for setting the plurality of virtual values to be nine from '1' to '9' between the lower and higher digital codes.

7. The all digital phase locked loop of claim 6, adapted for setting the step value, an interval between the plurality of virtual values, to be '1'.

8. The all digital phase locked loop of claim 7, adapted for setting the initial virtual value, among the plurality of virtual values, to be '5'.

9. A method of controlling an all digital phase locked loop, having
comparing phases of a target signal having a reference frequency (Fref) and a digital oscillation feedback signal having a feedback frequency (Ffb) based on an oscillation signal, **characterised in that** said method of controlling an all digital phase locked loop comprises:

setting one of a plurality of preset virtual values between lower and higher digital codes as a initial virtual value when the reference frequency (Fref) is a frequency included between two preset lower and higher digital codes, and controlling the initial virtual value according to a phase comparison result from the phase comparison to generate an adjusted virtual value;
generating a random number within a range of the plurality of virtual values;
comparing magnitudes between the adjusted virtual value (VA) and the random number (VB) to generate digital codes according to the comparison result; and
generating the oscillation signal according to the digital codes.

10. The method of claim 9, further comprising:

filtering the digital codes from the generating of the digital codes; and
dividing the oscillation signal from the generating of the oscillation signal at a preset dividing ratio to provide the digital oscillation feedback signal having the feedback frequency.

11. The method of claim 9, wherein in the comparing of the phases, a lead phase difference signal is provided when the phase of the target signal leads that of the digital oscillation feedback signal and a lag phase difference signal is provided when the phase of the target signal lags behind or is equal to that of the digital oscillation feedback signal.

12. The method of claim 11, wherein in the controlling of the virtual value, an adjusted virtual value obtained by adding a preset step value to the initial virtual value is provided when the phase difference signal is the lead phase difference signal, and an adjusted virtual value obtained by subtracting the preset step value from the initial virtual value is provided when the phase difference signal is the lag phase difference signal.

13. The method of claim 12, wherein in the generating of the digital code, the higher digital code is provided when the adjusted virtual value is higher than the random number, and the lower digital code is provided when the adjusted virtual value is equal to or lower than the random number.

14. The method of claim 13, wherein the plurality of virtual values are set to be nine from '1' to '9' between the lower and higher digital codes.

15. The method of claim 14, wherein the step value, an interval between the plurality of virtual values, is set to be '1'.

16. The method of claim 15, wherein the initial virtual value, among the plurality of virtual values, is set to be '5'.

**Patentansprüche**

1. Volldigitaler Phasenregelkreis, aufweisend:

   einen Phasenvergleicher (100) zum Vergleichen von Phasen eines Zielsignals, das eine Referenzfrequenz (Fref) aufweist, und eines digitalen Schwingungsrückkopplungssignals, das eine Rückkopplungsfrequenz (Ffb) aufweist, die auf einem Schwingungssignal basiert,
   **dadurch gekennzeichnet, dass** der volldigitale Phasenregelkreis umfasst:
   einen Regler (200) für virtuelle Werte zum Einstellen eines einer Mehrzahl voreingestellter virtueller Werte zwischen niedrigeren und höheren digitalen Codes als anfänglichem virtuellem Wert, wenn die Referenzfrequenz (Fref) eine Frequenz ist, die zwischen zwei voreingestellten niedrigeren und höheren digitalen Codes eingeschlossen ist, und zum Regeln des anfänglichen virtuellen Werts entsprechend einem Phasenvergleichsergebnis von dem Phasenvergleicher (100), um einen angepassten virtuellen Wert zu erzeugen;
   einen Zufallszahlgenerator (300) zum Erzeugen einer Zufallszahl innerhalb eines Bereichs der Mehrzahl virtueller Werte;
   einen Vergleicher (400) zum Vergleichen von Größenordnungen zwischen dem angepassten virtuellen Wert (VA), der von dem Regler (200) für virtuelle Werte erzeugt wird, und der Zufallszahl (VB), die von dem Zufallszahlgenerator (300) erzeugt wird, um entsprechend dem Vergleichsergebnis digitale Codes zu erzeugen; und
   einen digital gesteuerten Oszillator (600) zum Erzeugen des Schwingungssignals entsprechend den digitalen Codes von dem Vergleicher (400).

2. Volldigitaler Phasenregelkreis nach Anspruch 1, weiterhin umfassend:

   ein digitales Filter (500) zum Filtern der digitalen Codes von dem Vergleicher (400); und
   einen Teiler (700) zum Teilen des Schwingungssignals von dem digital gesteuerten Oszillator (700) mit einem voreingestellten Teilungsverhältnis, um das digitale Schwingungsrückkopplungssignal bereitzustellen, das die Rückkopplungsfrequenz (Ffb) aufweist.

3. Volldigitaler Phasenregelkreis nach Anspruch 1, wobei der Phasenvergleicher (100) zum Bereitstellen eines "Voreilende Phase"-Differenzsignals, wenn die Phase des Zielsignals derjenigen des digitalen Schwingungsrückkopplungssignals voreilt, ausgelegt ist und zum Bereitstellen eines "Nacheilende Phase"-Differenzsignals, wenn die Phase des Zielsignals derjenigen des digitalen Schwingungsrückkopplungssignals nacheilt oder gleich dieser ist, ausgelegt ist.

4. Volldigitaler Phasenregelkreis nach Anspruch 3, wobei der Regler (200) für virtuelle Werte zum Bereitstellen eines angepassten virtuellen Werts, der durch Addieren eines voreingestellten Schrittwerts zu dem anfänglichen virtuellen Wert erhalten wird, wenn das Phasendifferenzsignal das "Voreilende Phase"-Differenzsignal ist, ausgelegt ist und zum Bereitstellen eines angepassten virtuellen Werts, der durch Subtrahieren des voreingestellten Schrittwerts von dem anfänglichen virtuellen Wert erhalten wird, wenn das Phasendifferenzsignal das "Nacheilende Phase"-Differenzsignal ist, ausgelegt ist.

5. Volldigitaler Phasenregelkreis nach Anspruch 4, wobei der Vergleicher (400) zum Bereitstellen des höheren digitalen Codes, wenn der angepasste virtuelle Wert höher ist als die Zufallszahl, ausgelegt ist und zum Bereitstellen des niedrigeren digitalen Codes, wenn der angepasste virtuelle Wert gleich der oder niedriger als die Zufallszahl ist, ausgelegt ist.

6. Volldigitaler Phasenregelkreis nach Anspruch 5, der zum Einstellen der Mehrzahl virtueller Werte auf neun von "1" bis "9" zwischen den niedrigeren und höheren digitalen Codes ausgelegt ist.

**7.** Volldigitaler Phasenregelkreis nach Anspruch 6, der zum Einstellen des Schrittwerts, eines Intervalls zwischen der Mehrzahl virtueller Werte, auf "1" ausgelegt ist.

**8.** Volldigitaler Phasenregelkreis nach Anspruch 7, der zum Einstellen des anfänglichen virtuellen Werts unter der Mehrzahl virtueller Werte auf "5" ausgelegt ist.

**9.** Verfahren zum Steuern eines volldigitalen Phasenregelkreises, aufweisend:

Vergleichen von Phasen eines Zielsignals, das eine Referenzfrequenz (Fref) aufweist, und eines digitalen Schwingungsrückkopplungssignals, das eine Rückkopplungsfrequenz (Ffb) aufweist, die auf einem Schwingungssignal basiert, **dadurch gekennzeichnet, dass** das Verfahren zum Steuern eines volldigitalen Phasenregelkreises umfasst:

Einstellen eines einer Mehrzahl voreingestellter virtueller Werte zwischen niedrigeren und höheren digitalen Codes als anfänglichem virtuellem Wert, wenn die Referenzfrequenz (Fref) eine Frequenz ist, die zwischen zwei voreingestellten niedrigeren und höheren digitalen Codes eingeschlossen ist, und zum Regeln des anfänglichen virtuellen Werts entsprechend einem Phasenvergleichsergebnis aus dem Phasenvergleich, um einen angepassten virtuellen Wert zu erzeugen;
Erzeugen einer Zufallszahl innerhalb eines Bereichs der Mehrzahl virtueller Werte;
Vergleichen von Größenordnungen zwischen dem angepassten virtuellen Wert (VA) und der Zufallszahl (VB), um entsprechend dem Vergleichsergebnis digitale Codes zu erzeugen; und
Erzeugen des Schwingungssignals entsprechend den digitalen Codes.

**10.** Verfahren nach Anspruch 9, weiterhin umfassend:

Filtern der digitalen Codes aus der Erzeugung der digitalen Codes; und
Teilen des Schwingungssignals aus der Erzeugung des Schwingungssignals mit einem voreingestellten Teilungsverhältnis, um das digitale Schwingungsrückkopplungssignal bereitzustellen, das die Rückkopplungsfrequenz aufweist.

**11.** Verfahren nach Anspruch 9, wobei beim Vergleichen der Phasen ein "Voreilende Phase"-Differenzsignal bereitgestellt wird, wenn die Phase des Zielsignals derjenigen des digitalen Schwingungsrückkopplungssignals voreilt, und ein "Nacheilende Phase"-Differenzsignal bereitgestellt wird, wenn die Phase des Zielsignals derjenigen des digitalen Schwingungsrückkopplungssignals nacheilt oder gleich dieser ist.

**12.** Verfahren nach Anspruch 11, wobei beim Regeln des virtuellen Werts ein angepasster virtueller Wert, der durch Addieren eines voreingestellten Schrittwerts zu dem anfänglichen virtuellen Wert erhalten wird, bereitgestellt wird, wenn das Phasendifferenzsignal das "Voreilende Phase"-Differenzsignal ist, und ein angepasster virtueller Wert, der durch Subtrahieren des voreingestellten Schrittwerts von dem anfänglichen virtuellen Wert erhalten wird, bereitgestellt wird, wenn das Phasendifferenzsignal das "Nacheilende Phase"-Differenzsignal ist.

**13.** Verfahren nach Anspruch 12, wobei beim Erzeugen des digitalen Codes der höhere digitale Code bereitgestellt wird, wenn der angepasste virtuelle Wert höher ist als die Zufallszahl, und der niedrigere digitale Code bereitgestellt wird, wenn der angepasste virtuelle Wert gleich der oder niedriger als die Zufallszahl ist.

**14.** Verfahren nach Anspruch 13, wobei die Mehrzahl virtueller Werte auf neun von "1" bis "9" zwischen den niedrigeren und höheren digitalen Codes eingestellt wird.

**15.** Verfahren nach Anspruch 14, wobei der Schrittwert, ein Intervall zwischen der Mehrzahl virtueller Werte, auf "1" eingestellt wird.

**16.** Verfahren nach Anspruch 15, wobei der anfängliche virtuelle Wert unter der Mehrzahl virtueller Werte auf "5" eingestellt wird.

**Revendications**

**1.** Boucle à phase asservie entièrement numérique ayant

un comparateur de phase (100) destiné à comparer des phases d'un signal cible ayant une fréquence de référence (Fref) et d'un signal de rétroaction d'oscillation numérique ayant une fréquence de rétroaction (Ffb) d'après un signal d'oscillation, **caractérisée en ce que** ladite boucle à phase asservie entièrement numérique comprend :

une unité de commande de valeur virtuelle (200) destinée à établir l'une d'une pluralité de valeurs virtuelles préétablies entre des codes numériques inférieur et supérieur comme une valeur virtuelle initiale lorsque la fréquence de référence (Fref) est une fréquence incluse entre deux codes numériques inférieur et supérieur préétablis, et destinée à commander la valeur virtuelle initiale selon un résultat de comparaison de phase en provenance du comparateur de phase (100) afin de générer une valeur virtuelle ajustée ;
un générateur de nombre aléatoire (300) destiné à générer un nombre aléatoire au sein d'une plage de la pluralité de valeurs virtuelles ;
un comparateur (400) destiné à comparer des grandeurs entre la valeur virtuelle ajustée (VA) générée par l'unité de commande de valeur virtuelle (200) et le nombre aléatoire (VB) généré par le générateur de nombre aléatoire (300) afin de générer des codes numériques selon le résultat de comparaison ; et
un oscillateur à commande numérique (600) destiné à générer le signal d'oscillation selon les codes numériques en provenance du comparateur (400).

2. Boucle à phase asservie entièrement numérique selon la revendication 1, comprenant en outre :

un filtre numérique (500) destiné à filtrer les codes numériques en provenance du comparateur (400) ; et
un diviseur (700) destiné à diviser le signal d'oscillation en provenance de l'oscillateur à commande numérique (600) à un rapport de division préétabli afin de fournir le signal de rétroaction d'oscillation numérique ayant la fréquence de rétroaction (Ffb).

3. Boucle à phase asservie entièrement numérique selon la revendication 1, dans laquelle le comparateur de phase (100) est adapté pour fournir un signal de différence de phase d'avance lorsque la phase du signal cible est en avance sur celle du signal de rétroaction d'oscillation numérique et est adapté pour fournir un signal de différence de phase de retard lorsque la phase du signal cible est en retard par rapport à ou est égale à celle du signal de rétroaction d'oscillation numérique.

4. Boucle à phase asservie entièrement numérique selon la revendication 3, dans laquelle l'unité de commande de valeur virtuelle (200) est adaptée pour fournir une valeur virtuelle ajustée obtenue en additionnant une valeur de pas préétablie à la valeur virtuelle initiale lorsque le signal de différence de phase est le signal de différence de phase d'avance, et est adaptée pour fournir une valeur virtuelle ajustée obtenue en soustrayant la valeur de pas préétablie de la valeur virtuelle initiale lorsque le signal de différence de phase est le signal de différence de phase de retard.

5. Boucle à phase asservie entièrement numérique selon la revendication 4, dans laquelle le comparateur (400) est adapté pour fournir le code numérique supérieur lorsque la valeur virtuelle ajustée est supérieure au nombre aléatoire et est adapté pour fournir le code numérique inférieur lorsque la valeur virtuelle ajustée est inférieure ou égale au nombre aléatoire.

6. Boucle à phase asservie entièrement numérique selon la revendication 5, adaptée pour établir la pluralité de valeurs virtuelles comme étant neuf de « 1 à 9 » entre les codes numériques inférieur et supérieur.

7. Boucle à phase asservie entièrement numérique selon la revendication 6, adaptée pour établir la valeur de pas, un intervalle entre la pluralité de valeurs virtuelles, comme étant « 1 ».

8. Boucle à phase asservie entièrement numérique selon la revendication 7, adaptée pour établir la valeur virtuelle initiale, parmi la pluralité de valeurs virtuelles, comme étant « 5 ».

9. Procédé de commande d'une boucle à phase asservie entièrement numérique comprenant
la comparaison de phases d'un signal cible ayant une fréquence de référence (Fref) et d'un signal de rétroaction d'oscillation numérique ayant une fréquence de rétroaction (Ffb) d'après un signal d'oscillation, **caractérisé en ce que** ledit procédé de commande d'une boucle à phase asservie entièrement numérique comprend :

l'établissement de l'une d'une pluralité de valeurs virtuelles préétablies entre des codes numériques inférieur et supérieur comme une valeur virtuelle initiale lorsque la fréquence de référence (Fref) est une fréquence incluse entre deux codes numériques inférieur et supérieur préétablis, et la commande de la valeur virtuelle initiale selon un résultat de comparaison de phase en provenance de la comparaison de phase afin de générer une valeur virtuelle ajustée ;
la génération d'un nombre aléatoire au sein d'une plage de la pluralité de valeurs virtuelles ;
la comparaison de grandeurs entre la valeur virtuelle ajustée (VA) et le nombre aléatoire (VB) afin de générer des codes numériques selon le résultat de comparaison ; et
la génération du signal d'oscillation selon les codes numériques.

**10.** Procédé selon la revendication 9, comprenant en outre :

le filtrage des codes numériques à partir de la génération des codes numériques ; et
la division du signal d'oscillation à partir de la génération du signal d'oscillation à un rapport de division préétabli pour fournir le signal de rétroaction d'oscillation numérique ayant la fréquence de rétroaction.

**11.** Procédé selon la revendication 9, dans lequel, dans la comparaison des phases, un signal de différence de phase d'avance est fourni lorsque la phase du signal cible est en avance sur celle du signal de rétroaction d'oscillation numérique et un signal de différence de phase de retard est fourni lorsque la phase du signal cible est en retard par rapport à ou est égale à celle du signal de rétroaction d'oscillation numérique.

**12.** Procédé selon la revendication 11, dans lequel dans la commande de la valeur virtuelle, une valeur virtuelle ajustée obtenue en additionnant une valeur de pas préétablie à la valeur virtuelle initiale est fournie lorsque le signal de différence de phase est le signal de différence de phase d'avance, et une valeur virtuelle ajustée obtenue en soustrayant la valeur de pas préétablie de la valeur virtuelle initiale est fournie lorsque le signal de différence de phase est le signal de différence de phase de retard.

**13.** Procédé selon la revendication 12, dans lequel, dans la génération du code numérique, le code numérique supérieur est fourni lorsque la valeur virtuelle ajustée est supérieure au nombre aléatoire, et le code numérique inférieur est fourni lorsque la valeur virtuelle ajustée est inférieure ou égale au nombre aléatoire.

**14.** Procédé selon la revendication 13, dans lequel la pluralité de valeurs virtuelles sont établies comme étant neuf de « 1 à 9 » entre les codes numériques inférieur et supérieur.

**15.** Procédé selon la revendication 14, dans lequel la valeur de pas, un intervalle entre la pluralité de valeurs virtuelles, est établie comme étant « 1 ».

**16.** Procédé selon la revendication 15, dans lequel la valeur virtuelle initiale, parmi la pluralité de valeurs virtuelles, est établie comme étant « 5 ».

FIG. 1

FIG. 2

FIG. 3

| VB | VA | DIGITAL CODE (DN or DN+1) |
|----|----|----|
| 5 | 1 | DN |
| 1 | 2 | DN+1 |
| 7 | 1 | DN |
| 2 | 2 | DN |
| 3 | 3 | DN |
| 8 | 4 | DN |
| 4 | 5 | DN+1 |
| 9 | 4 | DN |
| 6 | 5 | DN |
| 0 | 6 | DN+1 |

FIG. 4

START

COMPARE PHASES OF TARGET SIGNAL TS AND DIGITAL OSCILLATION FEEDBACK SIGNAL DFS —— S100

S200

S300

GENERATE ADJUSTED VIRTUAL VALUE VA BY CONTROLLING INITIAL VIRTUAL VALUE SET AMONG A PLURALITY OF VIRTUAL VALUES BETWEEN PRESET LOWER AND HIGHER DIGITAL CODES DN AND DN+1 ACCORDING TO PHASE COMPARISON RESULT

GENERATE RANDOM NUMBER VB WITHIN RANGE OF THE PLURALITY OF VIRTUAL VALUES

VA

VB

GENERATE DIGITAL CODE ACCORDING TO COMPARISON RESULT BETWEEN ADJUSTED VIRTUAL VALUE VA AND RANDOM NUMBER VB —— S400

GENERATE OSCILLATION SIGNAL ACCORDING TO DIGITAL CODE —— S500

END?

END

FIG. 5

START

S100

TS PHASE >
DFS PHASE

COMPARISON
OF TS PHASE
WITH DFS PHASE

TS PHASE ≤
DFS PHASE

Slead → High

Slag → High

S200

FIG. 6

S100

S200

Slead=high

Slead=high?
or
Slag=high?

Slag=high

VA=VS+1

VA=VS−1

S400

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020100101005

- US 20080315928 A